# EUROPEAN PATENT SPECIFICATION

(11) **EP 1 121 694 B1**
(45) Date of publication and mention of the grant of the patent: **26.04.2006**
(21) Application number: 00965594.5
(22) Date of filing: 07.08.2000
(51) Int. Cl.: H01H 1/00, H01H 61/02, H01H 61/04, H01H 59/00

(54) **MICROELECTROMECHANICAL DEVICE HAVING SINGLE CRYSTALLINE COMPONENTS AND METALLIC COMPONENTS AND ASSOCIATED FABRICATION METHODS**
MIKROELEKTROMECHANISCHE ANORDNUNG MIT EINKRISTALLINEN KOMPONENTEN UND METALLISCHEN KOMPONENTEN UND ENTSPRECHENDE HERSTELLUNGSMETHODEN
DISPOSITIF MECANIQUE MICROELECTRIQUE A COMPOSANTS CRISTALLINS UNIQUES ET COMPOSANTS METALLIQUES, ET PROCEDES DE FABRICATION CORRESPONDANTS

(30) Priority: 25.08.1999 US 383053
(43) Date of publication of application: 08.08.2001
(73) Proprietor: Memscap S.A., 38926 Crolles Cedex (FR)
(72) Inventor: DHULER, Vijayakumar, R., Raleigh, NC 27613 (US)
(74) Representative: McKechnie, Neil Henry
(86) International application number: PCT/US2000/040577
(87) International publication number: WO 2001/015184

(56) References cited:
- WO-A-99/16096
- DE-C- 4 205 029
- US-A- 5 179 499
- US-A- 5 316 979
- US-A- 5 726 073
- US-A- 5 909 078
- NOWOROLSKI J M ET AL: "PROCESS FOR IN-PLANE AND OUT-OF-PLANE SINGLE-CRYSTAL-SILICON THERMAL MICROACTUATORS" SENSORS AND ACTUATORS A,CH,ELSEVIER SEQUOIA S.A., LAUSANNE, vol. A55, no. 1, 15 July 1996 (1996-07-15), pages 65-69, XP000641567 ISSN: 0924-4247
- KLAASSEN E H ET AL: "SILICON FUSION BONDING AND DEEP REACTIVE ION ETCHING: A NEW TECHNOLOGY FOR MICROSTRUCTURES" SENSORS AND ACTUATORS A,CH,ELSEVIER SEQUOIA S.A., LAUSANNE, vol. 52, no. 1/03, 1 March 1996 (1996-03-01), pages 132-139, XP000483098 ISSN: 0924-4247

## Description

### FIELD OF THE INVENTION

The present invention relates to microelectromechanical devices and associated fabrication methods and, more particularly, to microelectromechanical devices having both single crystalline components and metallic components as well as the associated fabrication methods.

### BACKGROUND OF THE INVENTION

Microelectromechanical structures (MEMS) and other microengineered devices are presently being developed for a wide variety of applications in view of the size, cost and reliability advantages provided by these devices. Many different varieties of MEMS devices have been created, including microgears, micromotors, and other micromachined devices that are capable of motion or applying force. These MEMS devices can be employed in a variety of applications including hydraulic applications in which MEMS pumps or valves are utilized, optical applications which include MEMS light valves and shutters, and electrical applications which include MEMS relays.

MEMS devices have relied upon various techniques to provide the force necessary to cause the desired motion within these microstructures. For example, electrostatic actuators have been used to actuate MEMS devices. See, for example, U.S. Patent Application Serial No. 09/320,891, assigned to MCNC, also the assignee of the present invention, which describes MEMS devices having electrostatic microactuators, the contents of which are incorporated herein by reference. In addition, controlled thermal expansion of an actuator or other MEMS component is another example of a technique for providing the necessary force to cause the desired motion within MEMS structures. See, for example, U.S. Patent No. 5,909,078 and U.S. Patent Application Serial Nos. 08/936,598; and 08/965,277, assigned to MCNC, also the assignee of the present invention, which describe MEMS devices having thermally actuated microactuators, the contents of which are incorporated herein by reference.

An example of a thermally actuated microactuator for a MEMS device comprises one or more arched beams extending between a pair of spaced apart supports. Thermal actuation of the microactuator causes further arching of the arched beams which results in useable mechanical force and displacement. The arched beams are generally formed from nickel using a high aspect ratio lithography technique which produces arched beams with aspect ratios up to 5:1. Although formed with high aspect ratio lithography, the actual nickel arched beams have rather modest aspect ratios and may therefore have less out-of-plane stiffness and be less robust than desired in some instances. Further, the lithography technique used to form nickel arched beams may result in the arched beams being spaced fairly far apart, thereby increasing the power required to heat the arched beams by limiting the amount that adjacent arched beams heat one another. In addition, the resulting microactuator may have a larger footprint than desired as a result of the spacing of the arched beams. Thus, there exists a need for arched beams having higher aspect ratios in order to increase the out-of-plane stiffness and the robustness of microactuators for MEMS devices. In addition, there is a desire for microactuators having more closely spaced arched beams to enable more efficient heating and a reduced size.

Nickel microactuators are typically heated indirectly, such as via a polysilicon heater disposed adjacent and underneath the actuator, since direct heating of the nickel structure (such as by passing a current therethrough) is inefficient due to the low resistivity of nickel. However, indirect heating of the microactuator of a MEMS device results in inefficiencies since not all heat is transferred to the microactuator due to the necessary spacing between the microactuator and the heater which causes some of the heat generated by the heater to be lost to the surroundings.

Nickel does have a relatively large coefficient of thermal expansion that facilitates expansion of the arched beams. However, significant energy must still be supplied to generate the heat necessary to cause the desired arching of the nickel arched beams due to the density thereof. As such, although MEMS devices having microactuators with nickel arched beams provide a significant advance over prior actuation techniques, it would still be desirable to develop MEMS devices having microactuators that could be thermally actuated in a more efficient manner in order to limit the requisite input power requirements.

Another example of a microelectromechanical device is cited in WO99/16096.

### SUMMARY OF THE INVENTION

The above and other needs are met by the present invention as disclosed in claim 1.

According to one advantageous embodiment, the microactuator is thermally actuated. In this embodiment, the microactuator preferably comprises a pair of spaced apart supports disposed on the substrate and at least one arched beam extending therebetween. The microactuator may also include an actuator member that is operably coupled to the at least one arched beam and extends outwardly therefrom. The microactuator further includes means for heating said at least one arched beam to cause further arching thereof, wherein the actuator member moves between a first position in which the actuator member is spaced apart from said at least one metallic structure and a second position in which the actuator member operably engages said at least one metallic structure.

In another embodiment of the present invention, the microactuator is electrostatically actuated. In this embodiment, an electrostatic microactuator may comprise, for instance, a microelectronic substrate having at least one stator disposed thereon. Preferably, the stator has a plurality of fingers protruding laterally therefrom. Further, the electrostatic microactuator includes at least one shuttle disposed adjacent the stator, wherein the shuttle is movable with respect to the substrate and has a plurality of fingers protruding laterally therefrom. The fingers protruding from the shuttle are preferably interdigitated with the fingers protruding from the stator. An actuator member is coupled to the shuttle, protrudes outwardly therefrom, and extends between a pair of spaced apart supports. Electrical biasing of the stator with respect to the shuttle causes movement of the shuttle such that the actuator member operably engages the metallic structure in response to the actuation of the electrostatic actuator.

Another advantageous aspect of the present invention comprises the associated method to form a microelectromechanical device having both single crystal components and metallic components. According to one preferred method, a microactuator, such as a thermally actuated microactuator or an electrostatic microactuator, is formed from a wafer comprised of a single crystalline material. At least one metallic structure is also formed upon a surface of a substrate such that at least one metallic structure is moveable relative to the substrate. The microactuator is then bonded upon the surface of the substrate such that portions of the microactuator are also moveable relative to the substrate in order that the microactuator may operably engage the metallic structure in response to thermal actuation thereof.

An alternative method of fabricating a microelectromechanical device having both single crystal components and metallic components in accordance with a preferred embodiment of the present invention comprises bonding a wafer comprised of a single crystalline material upon a surface of a substrate. After polishing the wafer to the desired configuration, at least one window may be defined through the wafer, extending to the substrate. Using the wafer as a template, at least one metallic structure may then be formed within said at least one window defined by the wafer and upon the surface of the substrate. A portion of the wafer surrounding the at least one metallic structure can then be etched away to permit the metallic structure to be moveable relative to the substrate. Either before or after the metallic structure is formed, a microactuator is formed from the wafer such that portions of the microactuator are moveable relative to the substrate and are capable of operably engaging the metallic structure in response to thermal actuation thereof.

Yet another alternative method of fabricating a microelectromechanical device having both single crystal components and metallic components in accordance with a preferred embodiment of the present invention comprise bonding a wafer comprised of a single crystalline material upon a surface of a substrate. After polishing the wafer to the desired configuration, a portion of the wafer can be etched away and at least one metallic structure formed upon the surface of the substrate such that the metallic structure is moveable relative to the substrate. Either before or after the metallic structure is formed, a microactuator is formed from the wafer such that portions of the microactuator are moveable relative to the substrate and are capable of operably engaging the metallic structure in response to thermal actuation thereof.

Thus, a MEMS device, such as a microrelay, can be formed in accordance with the present invention that includes actuators formed of single crystalline silicon, while other components of the MEMS device are formed of metal, such as nickel. Fabricating, for example, the arched beams of a thermally actuated microactuator or the interdigitated fingers of an electrostatic microactuator from single crystalline silicon allows the features to be formed with aspect ratios of up to at least 10:1, particularly by using a deep reactive ion etching process. The higher aspect ratios of the features and components increases their out-of-plane stiffness and constructs a more robust device. The fabrication techniques of the present invention also advantageously permit closer spacing of features and components. For example, the closer spacing between adjacent silicon arched beams of a thermally actuated microactuator results in more effective transfer of heat between adjacent arched beams. In addition, the single crystalline silicon microactuator can be directly heated, such as by passing a current therethrough. As will be apparent, direct heating of the microactuator is generally more efficient than indirect heating. Further, although the coefficient of thermal expansion of silicon is less than that of metals, such as nickel, silicon is significantly less dense than nickel such that for a given amount of power a silicon arched beam can generally be heated more than a corresponding nickel arched beam. Therefore, the MEMS device of the present invention can have greater out-of-plane stiffness, can be more robust and can be more efficiently heated than conventional MEMS microactuators having metallic components.

### BRIEF DESCRIPTION OF THE DRAWINGS

Some of the advantages of the present invention having been stated, others will appear as the description proceeds, when considered in conjunction with the accompanying drawings in which:
**FIG. 1** is a plan view of a MEMS device and, in particular, a microrelay, in accordance with one embodiment of the present invention.
**FIGS. 2A-2E** are cross-sectional views illustrating a sequence of operations performed during the fabrication of a MEMS device, such as a microrelay, according to an embodiment of the present invention.
**FIGS. 3A-3F** are cross-sectional views illustrating an alternate sequence of operations performed during the fabrication of a MEMS device, such as a microrelay, according to another embodiment of the present invention.
**FIGS. 4A-4F** are cross-sectional views illustrating an alternate sequence of operations performed during the fabrication of a MEMS device, such as a microrelay, according to yet another embodiment of the present invention.
**FIG. 5** is a plan view of an electrostatic microactuator in accordance with one embodiment of the present invention.

### DETAILED DESCRIPTION OF THE INVENTION

The present invention now will be described more fully hereinafter with reference to the accompanying drawings, in which preferred embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art. Like numbers refer to like elements throughout.

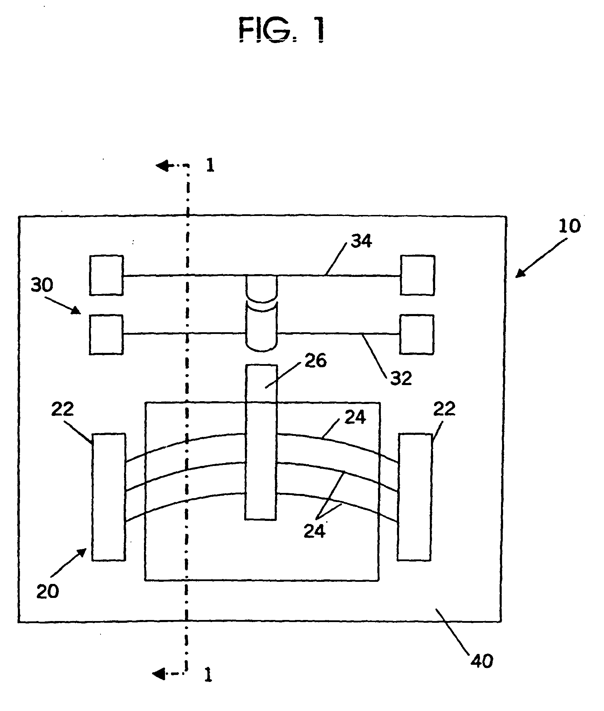

**FIG. 1** discloses an embodiment of a MEMS device and, in particular, a microrelay, indicated generally by the numeral **10,** which includes the features of the present invention. The microrelay **10** generally comprises a microactuator **20** and at least one adjacent metallic structure **30.** While the substrate **40** can be formed of a variety of materials, the substrate **40** preferably comprises a wafer of a single crystalline material such as silicon. Although the microactuator can have various forms as is further described herein, the microactuator **20** of one advantageous embodiment is thermally actuated and includes a pair of spaced apart supports **22** affixed to the substrate **40** and at least one and, more preferably, a number of arched beams **24** extending between the spaced apart supports **22.** According to the present invention, the supports **22** and the arched beams **24** are preferably formed of a single crystalline material, such as single crystalline silicon, and, more preferably, as a unitary structure formed from the same single crystalline silicon wafer.

According to one advantageous aspect of the present invention, the arched beams **24** are comprised of single crystal silicon which has a relatively low coefficient of thermal expansion of 2.5 × 10⁻⁶ /°K, which is about one-fifth that of nickel. Surprisingly, however, silicon arched beams generally require less energy to heat to the same temperature as compared to nickel arched beams of the same size and shape. The reduction in energy required to heat the silicon arched beams results, in part, from the density of silicon of 2.33 g/cm³ that is only about one-fourth that of nickel. In addition, silicon arched beams can be directly heated that provides more efficient heating than the indirect heating typically used for nickel arched beams.

Another advantage of silicon arched beams **24** is that a high aspect ratio lithography process (which currently limits the aspect ratio of nickel arched beams to 5:1) is not required. Instead, a deep reactive ion etching process is used in the formation of silicon arched beams, wherein this etching process can routinely produce aspect ratios of 10:1. The high aspect ratios for silicon arched beams increases the out-of-plane stiffness of the arched beams and contributes to more robust devices. In addition, the deep reactive ion etching process permits the arched beams to be more closely spaced than nickel arched beams, thus increasing the energy efficiency of the microactuator **20** due to heat transfer between adjacent silicon arched beams. For example, the silicon arched beams of the MEMS device of the present invention having an aspect ratio of 10:1 can have a center-to-center spacing of 30 µm and a gap between adjacent arched beams of 5µm. For the foregoing reasons, a microactuator having silicon arched beams is therefore much more efficiently heated than conventional microactuators with nickel arched beams since the beams may be placed in closer proximity to adjacent beams. For instance, in one embodiment, a 40% reduction in the energy required to heat the silicon arched beams is obtained by reducing the configuration of silicon arched beams having a 10:1 aspect ratio from a center-to-center spacing of 22 µm with a 12 µm gap between adjacent arched beams to a center-to-center spacing of 10 µm with a 5µm gap between adjacent arched beam.

The microactuator **20** also includes means for heating the arched beams **24.** In one embodiment of the present invention, the microactuator **20** is thermally actuated by direct heating of the arched beams **24.** For example, a potential difference can be applied between electrodes disposed upon the spaced apart supports **22** which causes a current to flow through the arched beams **24.** The resistivity of the arched beams **24** causes heat to be produced in the arched beams **24** due to the current, thereby providing the necessary thermal actuation. Alternatively, the arched beams **24** can be indirectly heated to produce the thermal actuation of the microactuator **20** such as, for example, by a change in the ambient temperature about the arched beams **24** or by an external polysilicon heater disposed adjacent thereto. As shown in **FIG. 1,** the arched beams **24** are arched in a direction which preferably extends parallel to the substrate in the desired or predetermined direction of motion of the microactuator **20.** Thus, heating of the arched beams **24** causes further arching thereof in the predetermined direction, thereby resulting in useable displacement and mechanical force.

The microactuator **20** may also include a lengthwise extending actuator member **26** coupled to the arched beams **24** and extending outwardly therefrom in the direction of motion. The actuator member **26** therefore serves as a coupler to mechanically couple a plurality of arched beams **24** between the spaced apart supports **22** as shown in **FIG. 1.** As such, further arching of the arched beams **24** in the predetermined direction displaces the actuator member **26** in the same predetermined direction. By mechanically coupling multiple arched beams with the actuator member **26,** the resulting microactuator **20** provides a higher degree of controlled displacement and force than would be provided by a single arched beam.

As further shown in **FIG. 1,** the microactuator **20** of the present invention is preferably designed to actuate at least one metallic structure **30** disposed adjacent the microactuator **20** and in the same plane as the microactuator. As also shown, the at least one metallic structure **30** can include two metallic structures **32** and **34** with one of the metallic structures **32** being moveable while the other metallic structure **34** is either moveable or fixed relative to the substrate. Although the metallic structures can be formed in different manners, the metallic structures of the illustrated embodiment each include a metallic member suspended by means of a pair of tethers from respective anchors. While the anchors are affixed to the substrate, the metallic members can move relative to the substrate. Although not necessary for the practice of the present invention, the faces of the metallic members may have complimentary shapes to facilitate mating of the metallic members. The actuator member **26,** in a non-actuated or ambient state, may be either spaced apart from or touching the moveable metallic structure **32.** Upon thermal actuation of the microactuator **20,** such as by direct heating of the arched beams **24,** however, the actuator member **26** is preferably urged into engagement with the moveable metallic structure **32.** Since the metallic structure **32** is moveable relative to the substrate, further actuation of the microactuator **20** will urge the moveable metallic structure **32** into contact with the other metallic structure **34.** As such, the MEMS device of this embodiment may serve as a microrelay by controllably establishing contact between the first and second metallic members that form the pair of electrical contacts of the microrelay. By appropriately electrically connecting respective circuits or the like to the first and second metallic structures, the circuits can be controllably connected by selectively thermally actuating the microactuator.

As described below, the metallic structures **30** are typically formed on a substrate 40 which may be comprised of a variety of materials, such as silicon, glass, or quartz. The metallic structures **30** are preferably formed of metal, such as nickel, that is deposited on the substrate **40** in the same plane as the microactuator by means of an electroplating process: The metallic structures **30** are typically separated from the substrate **40** by a release layer (not shown). By removing the release layer after forming the metallic structure, such as by wet etching the release layer, the metallic structure is then capable of movement with respect to the substrate **40.**

In accordance with the present invention, several associated methods may be used to produce the MEMS device, such as a microrelay **10,** having both single crystal components and metallic components. The associated methods described herein disclose the fabrication steps related to one embodiment of a thermally actuated microactuator in the production of a MEMS device. It will be appreciated by those skilled in the art that the fabrication steps herein described are also applicable (with appropriate modifications) to various other microactuators, such as electrostatic microactuators, comprised of a single crystalline material, such as a single crystalline silicon. Thus, it is understood that the associated methods as described herein may be used to produce MEMS devices having both metallic components and single crystal components, including various types of single crystalline microactuators, such as thermally actuated microactuators and electrostatic microactuators.

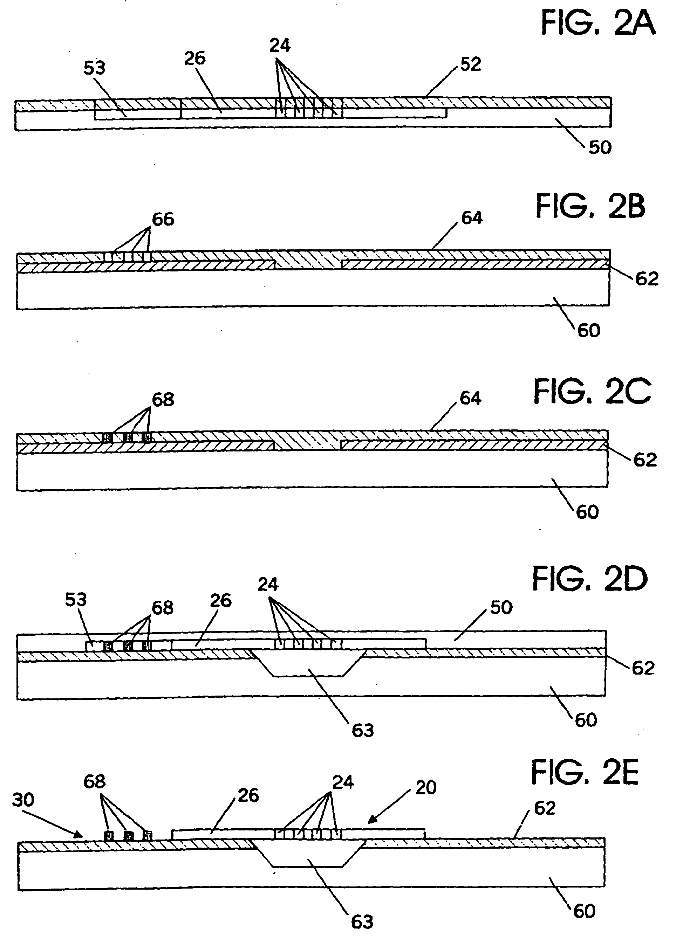

As shown in **FIG. 2** and according to one advantageous method, at least one metallic structure **30** may be formed on one wafer while the silicon microactuator components may be fabricated from another wafer. Once the structures are formed, the two wafers are bonded together, for example, by an anodic bonding process or another type of low temperature bonding, such as eutectic bonding.

More particularly, the microactuator **20** is formed by etching the components, such as the supports and arched beams, from a single crystalline silicon wafer. In contrast, the said at least one metallic structure **30** is formed by electroplating a metal, such as nickel, on another wafer, which may be comprised, for instance, of silicon or quartz. The two wafers are then bonded together such that the microactuator **20** is disposed adjacent the metal structures **30** and is capable of engagement therewith. The wafer from which the microactuator **20** is formed is then polished back or etched to release at least some of the silicon components, and, more particularly, to allow the arched beams 24 to be moveable relative to the substrate.

As shown in more detail in **FIG. 2A,** a microactuator **20** may be formed from a single crystalline silicon wafer by initially depositing a mask layer **52** upon a single crystalline silicon wafer substrate **50**. It will be understood by those having skill in the art that when a layer or element is described herein as being "on" another layer of element, it may be formed directly on the layer, at the top, bottom or side surface area, or one or more intervening layers may be provided between the layers. The mask layer **52** is typically a photoresist or a light sensitive polymer material. Once deposited upon the wafer **50,** the mask layer **52** is patterned such that the photoresist which remains on the wafer **50** defines a cavity **53** (that will receive the metallic components as described hereinbelow) and the microactuator **20,** generally comprised of a pair of spaced apart supports **22,** at least one arched beam **24,** and an actuator member **26.** Once the photoresist is patterned, the wafer **50** is etched so as to form the microactuator structure **20** and the cavity **53.** Preferably, the wafer **50** is etched by deep reactive ion etching capable of forming thin silicon structures from the wafer **50** having aspect ratios on the order of 10:1. The high aspect ratios for silicon arched beams increases the out-of-plane stiffness of the structures and contributes to more robust devices. In addition, deep reactive ion etching allows closer spacing of the silicon arched beams, such as a center-to-center spacing of 10 µm, thus increasing the efficiency with which the arched beams are heated due to increased heat transfer between adjacent silicon arched beams.

In order to fabricate said at least one metallic structure **30,** a sacrificial plating base **62** is deposited on a separate substrate **60** as shown in **FIG. 2B.** The sacrificial plating base **62** can be any of a variety of plating bases known to those skilled in the art, such as a three-layer structure formed of titanium (adjacent the substrate), copper, and titanium or a three-layer structure formed of titanium (adjacent the substrate), copper, and titanium where chromium portions are deposited adjacent the substrate in selective locations instead of titanium. The chromium portions of the plating base **62** define areas in which components are not released from the substrate, and may be used, for example, in the plating base **62** underlying the anchors for the metallic structures **30.** Following deposition of the plating base **62,** a thick layer of photoresist **64** is deposited and lithographically patterned to open a number of windows **66** to the sacrificial plating base **62.** The windows **66** opened within the photoresist **64** correspond to and define said at least one metallic structure **30,** comprising, for example, the contacts of a microrelay. Thereafter, a metal **68,** such as nickel, copper, or gold, is electroplated within the windows **66** defined by the photoresist **64** to produce the metallic structure **30** shown in **FIG. 2C.** Although any of a variety of metals that are capable of being electroplated can be utilized, nickel is particularly advantageous since nickel can be deposited with low internal stress in order to further stiffen the resulting structure to out-of-plane deflection. Electroplating of nickel layers with low internal stress is described in "The Properties of Electrodeposited Metals and Alloys," H. W. Sapraner, *American Electroplaters and Surface Technology Society,* pp. 295-315 (1986), the contents of which are incorporated herein by reference.

Once the metal **68** has been electroplated, the photoresist **64** is removed. Preferably, a cavity **63** is then formed in the substrate **60** through a predetermined opening in the plating base **62** using, for example, wet etching. The cavity **63** is positioned to underlie the arched beams **24** of the microactuator **20** in order to facilitate movement of the arched beams relative to the substrate while concurrently aiding in the thermal isolation of the arched beams from the substrate. The remaining plating base **62** may then also be removed so as to release a portion of the metallic structures **30** from the substrate **60** to produce, for instance, a moveable metallic structure **32.** According to this embodiment of the present invention, the duration of the etch of the plating base **62** is preferably controlled, or a plating base **62** consisting of selective areas of chromium-copper-titanium is used, so that the portion of the plating base **62** underlying the metallic member and the tethers is removed without removing a significant portion of the plating base **62** that underlies the corresponding anchors. Thus, the metallic structure **30** remains anchored at either or both ends. Once the microactuator **20** and said at least one metallic structure **30** have been formed, the wafer **50** and the substrate **60** are bonded together by a low temperature bonding process, such as by a eutectic bonding or an anodic bonding process, as shown in **FIG. 2D.** As shown in **FIG. 2E,** the wafer **50** is then polished and etched to release the microactuator **20** and, in particular, the arched beams from the remainder of the wafer **50.**

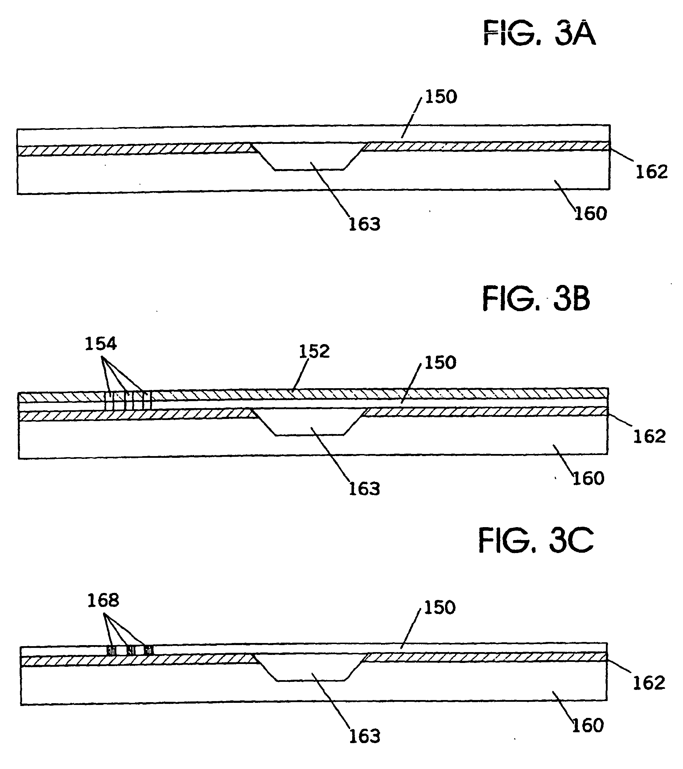

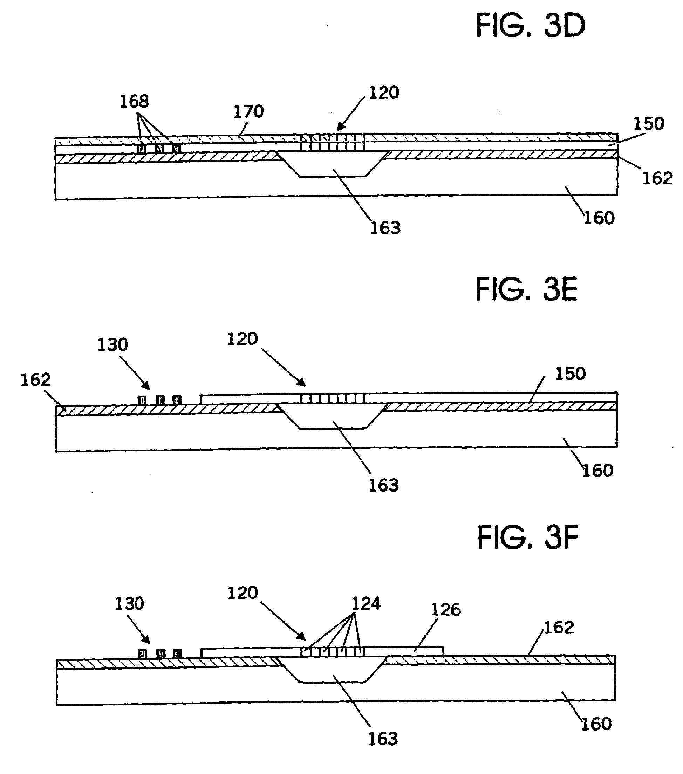

An alternative method of fabricating a MEMS device, such as a microrelay, according to the present invention is shown in **FIG. 3.** According to this method and as shown in **FIG. 3A,** a sacrificial plating base **162** is initially deposited upon a substrate **160.** As described above, the substrate typically defines a cavity **163** that will underlie the silicon arched beams of the resulting microactuator. A wafer **150,** such as a single crystalline silicon wafer, is then bonded to the substrate **160** by a low temperature bonding process such as, for example, a eutectic bonding or an anodic bonding process and the wafer **150** then polished to the desired thickness. As shown in **FIG. 3B,** a photoresist layer **152** is applied to the single crystalline silicon wafer **150** and patterned to form a number of windows **154** therethrough to the wafer **150.** The areas of the wafer **150** within the windows **154** are then etched, such as by a deep reactive ion etch process, to further extend the windows **154** through the wafer **150** so as to expose the sacrificial plating base **162** on the substrate **160.** According to this embodiment of the present invention, the wafer **150** thus advantageously comprises a plating template to facilitate the plating of the metallic components. As shown in **FIG. 3C,** a metal **168** is then electroplated within the windows **154** formed through the wafer **150** so as to fabricate the metal structures **130** corresponding, for example, to the contacts of the relay. Accordingly, the method of this embodiment is particularly advantageous since the single crystalline wafer **150** actually serves as a plating template, thereby precisely positioning the metallic components relative to the microactuator formed from the single crystalline wafer. Since the wafer **150** may be etched by a deep reactive ion etch process, windows **154** with aspect ratios on the order of 10:1 may be produced, thereby allowing high aspect ratio electroplating of the metal 168 and thus producing higher aspect ratios metal structures **130** than attainable with conventional photolithography processes. As shown in **FIG. 3D,** the wafer **150** is coated with a photoresist **170** and etched to form a microactuator structure **120** that is preferably disposed adjacent the previously created metallic structures **130.** A portion of the wafer **150** surrounding the metallic structures **130** is then etched away such that the metallic structures **130** are freestanding on the substrate **160,** as shown in **FIG. 3E.** As shown in **FIG. 3F,** the embodiment of the method also includes the appropriate etching steps, similar to those described above, to release the arched beams **124** and the metallic structures **130** from the underlying substrate to complete the microrelay **10.**

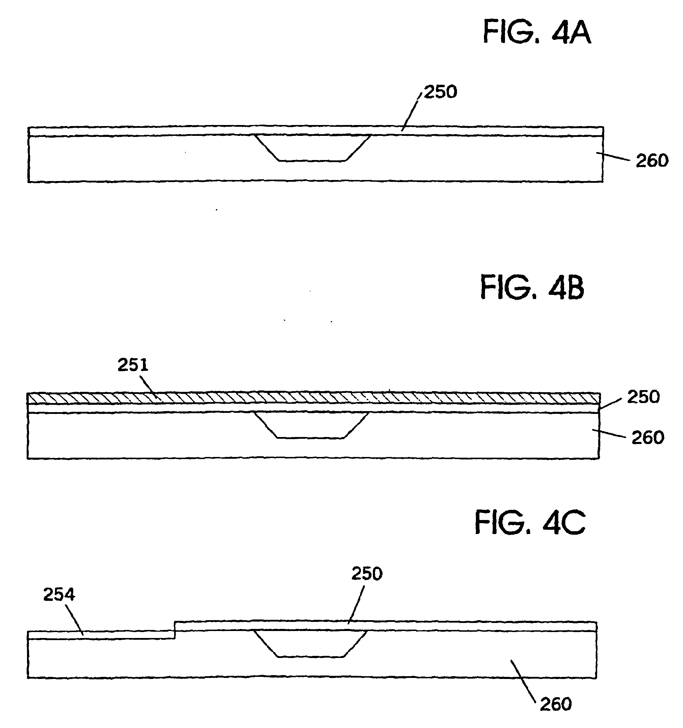

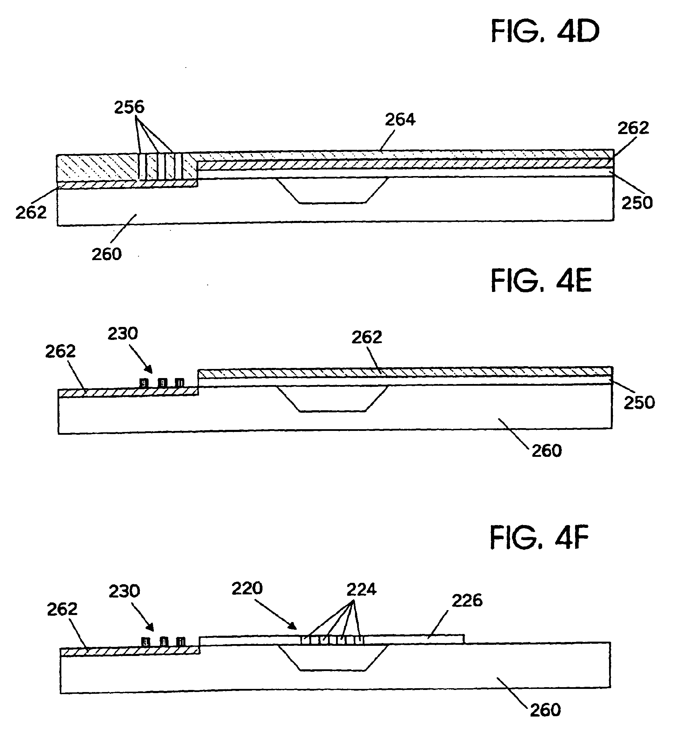

A further alternative method of fabricating a MEMS device, such as a microrelay, in accordance with the present invention is shown in **FIG. 4.** As shown in **FIG. 4A,** a substrate **260,** typically having a cavity as described above, is provided and has a single crystalline silicon wafer **250** disposed thereon and bonded thereto using, for example, a eutectic bonding process, an anodic bonding process, or a fusion bonding process. The wafer **250** is polished to the desired thickness before a photoresist **251** is applied to the wafer **250,** as shown in **FIG. 4B.** Portions of the wafer **250** are then etched away to expose the substrate **260** and thereby define at least one window **254** in which said at least one metallic structure **230** is to be formed, as shown in **FIG. 4C.** If necessary, a plating base **262** is deposited within the window **254** before the window **254** is coated with a photoresist **264** that is subsequently patterned to define apertures **256** in the photoresist corresponding to said at least one metallic structure **230,** as shown in **FIG. 4D.** At least one metallic structure **230** is then formed within the apertures **256** by an electroplating process in which a metal such as nickel is deposited within the apertures **256.** As shown in **FIG. 4E,** the photoresist is then be removed such that only the metallic structures **230** remain.

In addition, either before or after forming the at least one metallic structure **230,** the wafer **250** having the plating base **262** disposed thereon is coated with a photoresist (not shown). The photoresist is subsequently patterned and etched to form a microactuator structure **220** adjacent to and interoperable with said at least one metallic structure **230.** Further, as described above and shown **in FIG. 4F,** this embodiment of the method also preferably includes etching steps to remove the excess plating base **262** on the wafer **250** and release the arched beams **224** and metallic structures **230** from the underlying substrate **260.**

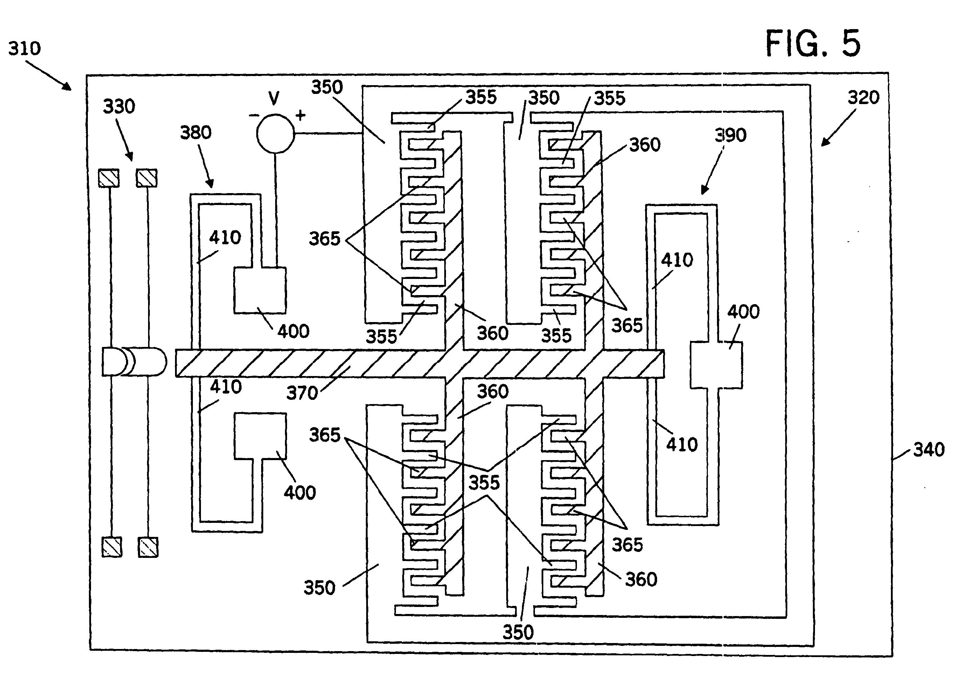

The MEMS device of the present invention can include other types of single crystalline microactuators in addition to thermally actuated microactuators. For example, still another advantageous aspect of the present invention is shown in **FIG. 5** and comprises an electrostatic microactuator **320** as an alternate mechanism to a thermally actuated microactuator for actuating a MEMS device, such as a microrelay **310.** The electrostatic microactuator **320** is preferably comprised of a single crystalline material, such as a single crystalline silicon, which is disposed on a substrate **340.** As previously described, at least one metallic structure **330** is also disposed on the substrate **340** adjacent the microactuator **320** and on substantially the same plane with respect thereto. Further, the microactuator **320** is adapted to operably contact the at least one metallic structure **330** upon actuation thereof.

More particularly and according to one embodiment of the present invention, an electrostatic microactuator **320** as shown in **FIG. 5** may comprise, for instance, a microelectronic substrate **340** having at least one stator **350** disposed thereon and anchored thereto. Each stator **350** has a plurality of fingers **355** protruding laterally therefrom. Further, the electrostatic microactuator **320** includes at least one shuttle **360** correspondingly disposed adjacent the at least one stator **350.** Preferably, the shuttle **360** is movable with respect to the substrate **340** and has a plurality of fingers **365** protruding laterally therefrom and interdigitated with the fingers **355** protruding from the stator **350.** An actuator member **370** is coupled to the at least one shuttle **360,** protrudes outwardly therefrom toward the at least one metallic structure **330,** and extends between a pair of spaced apart supports **380** and **390.** Each support **380** and **390** includes at least one and, more typically, a pair of anchors **400** anchored to the substrate **340** and a spring member **410** coupled to each anchor **400.** Each spring member **410** is movable with respect to the substrate **340** and is operably coupled to the actuator member **370.**

In order to provide the necessary actuation of the microactuator **320,** an electrical bias is applied between the at least one stator **350** and the at least one shuttle **360** such as, for instance, through electrodes (not shown) affixed to an anchor **400** and the stator **350.** Application of an electrical bias, such as a voltage bias, between the stator **350** and the shuttle **360** produces electric fields of opposing polarity about the interdigitated fingers **355** and **365** and thereby cause the fingers **355** and **365** to attract each other. The attractive force produced by the applied voltage bias thus causes movement of the shuttle **360** toward the stator **350** such that the actuator member **370** operably engages one of the metallic structures **330,** thereby closing the contacts of the microrelay **310** in response to the actuation of the electrostatic actuator **320.** On removal of the voltage bias, the attractive force between the stator **350** and the shuttle **360** dissipates and the spring members **380** and **390** return the actuator member **370** to a rest position disengaged from the metallic structures **330,** thereby opening the contacts of the microrelay **310.**

MEMS devices that include microactuators other than thermally actuated microactuators can be fabricated according to the various fabrication methods set forth above in which the microactuator is formed of a single crystalline material, such as single crystalline silicon, while other components are formed of metal so as to lie in the same plane as the microactuator. For example, a MEMS device that includes an electrostatic microactuator as shown in **FIG. 5** and described above can be fabricated according to the foregoing fabrication techniques. In this instance, the stator **350,** the shuttle **360** and the spaced apart supports **380, 390** of the electrostatic microactuator would preferably be formed of a single crystalline material in the same fashion as the spaced apart supports **22,** the actuator member **26** and the arched beams **24** of a thermally actuated microactuator **20** are formed of a single crystalline material in the embodiments of the methods described above. In addition, the metallic components **330** of the electrostatically actuated MEMS device can be formed, such as by electroplating, as also described above so as to lie in the same plane as the electrostatic microactuator.

Thus, a MEMS device, such as a microrelay, can be formed in accordance with the present invention that includes a microactuator formed of single crystalline silicon, while other components of the MEMS device are formed of metal, such as nickel, disposed on a substrate adjacent the microactuator and on substantially the same plane therewith. Fabricating features and/or components of the microactuator from single crystalline silicon allows the features and/or components to be formed with aspect ratios of up to at least 10:1, particularly by using a deep reactive ion etching process. The higher aspect ratios of the components increases their out-of-plane stiffness and constructs a more robust device. The fabrication techniques of the present invention also permits features and/or components to be more closely spaced. The closer spacing, for example, between adjacent silicon arched beams in a thermally actuated microactuator, results in more effective transfer of heat between adjacent arched beams. In addition, the single crystalline silicon microactuator in a thermally actuated microactuator can be directly heated, such as by passing a current therethrough, which is generally more efficient than indirect heating. Further, although the coefficient of thermal expansion of silicon is less than that of metals, such as nickel, silicon is significantly less dense than nickel such that for a given amount of power a silicon arched beam can generally be heated more than a corresponding nickel arched beam. Therefore, the MEMS device of the present invention can have greater out-of-plane stiffness, can be more robust and can be more efficiently heated than conventional MEMS microactuators having metallic arched beams.

## Claims

1. A microelectromechanical device including a microelectronic substrate (40), a microactuator (20) disposed on the substrate, and at least one structure (30) disposed on the substrate and spaced from the microactuator, the microactuator being adapted to operably contact the at least one structure in response to actuation thereof, the microelectromechanical device being
**CHARACTERIZED BY**:
the microactuator being comprised of a single crystalline material; and the at least one structure being comprised of a metallic structure.

2. A microelectromechanical device according to Claim 1 wherein the at least one metallic structure comprises a plurality of metallic structures, and
at least one (32) of the plurality of metallic structures being movable such that thermal actuation of the microactuator brings the microactuator into operable contact with the moveable metallic structure, thereby allowing the moveable metallic structure to contact at least one (34) of the plurality of metallic structures such that the metallic structures may be selectively brought into contact in response to thermal actuation of the microactuator.

3. A microelectromechanical device according to Claim 1, further **CHARACTERIZED BY** the microactuator and the at least one metallic structure being on a single plane.

4. A microelectromechanical device according to Claim 3 wherein the microactuator is further **CHARACTERIZED BY**:
at least one stator (350) having a plurality of fingers (355) protruding therefrom and disposed on the substrate;
at least one shuttle (360) disposed adjacent the stator and movable with respect thereto, the shuttle having a plurality of fingers (365) protruding therefrom, the fingers being interdigitated with the fingers protruding from the stator;
at least one support (380, 390) disposed on the substrate;
an actuator member (370) operably coupled to the at least one shuttle and the at least one support; and
means for electrically biasing the at least one stator with respect to the at least one shuttle to cause movement of the shuttle such that the actuator member moves between a first position in which the actuator member is spaced apart from said at least one metallic structure and a second position in which the actuator member operably engages the at least one metallic structure.

5. A method of fabricating a microelectromechanical device having components formed of a single crystalline material and components formed of a metallic material according to claim 1, comprising the steps of:
forming a microactuator (20) from a wafer (50) comprised of a single crystalline material;
forming at least one metallic structure (30) upon a substrate (60) such that the metallic structure is movable relative to the substrate; and
bonding the wafer and the substrate to one another.

6. A method according to Claim 5 further wherein the bonding step is being performed prior to either or both of the forming steps.

7. A method according to Claim 5 further wherein bonding the microactuator to the first major surface of the substrate follows both of the forming steps such that portions of the microactuator are movable relative to the substrate to operably engage the metallic structure in response to actuation thereof.

8. A method according to Claim 7 wherein the step of forming at least one metallic structure comprises the steps of:
depositing a sacrificial plating base (62) on a substrate;
depositing a photoresist (64) on the plating base;
patterning the photoresist to open at least one window (66) to the plating base defining the shape of the at least one metallic structure; and
electroplating metal (68) within the at least one window to form the at least one metallic structure.

9. A method according to Claim 6 wherein
the bonding step is performed prior to both of the forming steps; and
the step of forming at least one metallic structure comprises:
defining at least one window through the wafer;
forming at least one metallic structure within the at least one window through the wafer; and
forming a microactuator from the wafer such that portions of the microactuator are movable relative to the substrate to operably engage the metallic structure in response to actuation thereof.

10. A method according to Claim 6 wherein
the bonding step is performed prior to both of the forming steps;
the step of forming at least one metallic structure comprises forming at least one metallic structure upon a surface of the substrate such that the metallic structure is movable relative to the substrate; and
the step of forming a microactuator comprises forming a microactuator from the wafer such that portions of the microactuator are movable relative to the substrate in order to operably engage the metallic structure in response to actuation thereof.

## Patentansprüche

1. Ein mikroelektromechanisches Gerät mit einem mikroelektronischen Träger (40) und Mikroaktuator (20), die auf dem Träger angeordnet sind, und der mindestens einen Struktur (30), die auf dem Träger in einem gewissen Abstand vom Mikroaktuator angebracht ist, wobei der Mikroaktuator so angepasst ist, dass er bei seiner Betätigung durchführbar die mindestens eine Struktur berührt, wobei das mikroelektromechanische Gerät **dadurch gekennzeichnet ist, dass** der Mikroaktuator aus einem einzelnen Kristallmaterial besteht, und dass mindestens eine Struktur eine Metallstruktur ist.

2. Ein mikroelektromechanisches Gerät nach Anspruch 1, wobei die mindestens eine Metallstruktur aus einer Pluralität von Metallstrukturen besteht, und mindestens eine (32) der Pluralität von Metallstrukturen beweglich ist, so dass bei thermischer Betätigung des Mikroaktuators der Mikroaktuator durchführbar mit der beweglichen Metallstruktur in Berührung kommt, wobei ermöglicht wird, dass die bewegliche Metallstruktur mindestens eine (34) der Pluralität von Metallstrukturen berührt, so dass die Metallstrukturen bei der thermischen Betätigung des Mikroaktuator selektiv in Kontakt gebracht werden können.

3. Ein mikroelektromechanisches Gerät nach Anspruch 1, das weiterhin durch den Mikroaktuator und die mindestens eine Metallstruktur, die sich auf derselben Ebene befinden, **gekennzeichnet** ist.

4. Ein mikroelektromechanisches Gerät nach Anspruch 3, wobei der Mikroaktuator weiterhin **gekennzeichnet ist durch**:
mindestens einen Stator (350), der eine Pluralität von Fingern (355) hat, die aus ihm herausragen und auf dem Träger angeordnet sind;
mindestens einen Shuttle (360), der neben dem Stator angeordnet ist und im Verhältnis dazu beweglich ist, wobei der Shuttle eine Pluralität von Fingern hat, die aus dem Stator herausragen; mindestens eine Stütze (380, 390), die auf dem Träger angeordnet ist;
ein Aktuatorelement (370), das an dem mindestens einen Shuttle und an der mindestens einen Stütze durchführbar angekoppelt ist; und
ein Mittel zum elektrischen Betrieb des mindestens einen Stators bezüglich des mindestens einen Shuttles, um eine solche Bewegung des Shuttles zu bewirken, dass sich das Aktuatorelement zwischen einer ersten Position bewegt, auf der sich das Aktuatorelement in einem gewissen Abstand von mindestens einer der genannten Metallstrukturen davon befindet, und eine zweite Position, auf der das Aktuatorelement durchführbar die mindestens eine Metallstruktur einrastet.

5. Eine Methode zur Fertigung eines mikroelektromechanischen Geräts, das Komponenten hat, die aus einem Einzelkristallmaterial geformt sind, und Komponenten, die aus einem metallischen Material geformt sind, nach Anspruch 1, der aus folgenden Schritten besteht:
Formen eines Mikroaktuators (20) aus einer Halbleiterscheibe (50), die aus einem Einzelkristallmaterial besteht;
Formen von mindestens einer Metallstruktur (30) auf einem Träger; und Zusammenkleben der Halbleiterscheibe und des Trägers.

6. Eine Methode nach Anspruch 5, wobei der Schritt des Klebens vor einem oder vor beiden Schritten des Formens durchgeführt wird.

7. Eine Methode nach Anspruch 5, wobei das Kleben des Mikroaktuators auf die erste größere Oberfläche des Trägers auf die beiden Schritte des Formens folgt, so dass Teile des Mikroaktuators relativ zum Träger bewegt werden können, um bei seiner Betätigung durchführbar die Metallstruktur einzurasten.

8. Eine Methode gemäß Anspruch 7, wobei der Schritt des Formens von mindestens einer Metallstruktur aus den Schritten des Anbringens einer , Schutzplattierungsbasis (62) auf einem Träger besteht;
Auftragen eines Fotolacks (64) auf die Plattierungsbasis;
Nachbilden des Fotolacks, um mindestens ein Fenster (66) zur Plattierungsbasis hin zu öffnen,
wobei die Form von der mindestens einen Metallstruktur definiert wird; und galvanisiertes Metall (68) innerhalb des mindestens einen Fensters, um die mindestens eine Metallstruktur zu formen.

9. Eine Methode gemäß Anspruch 6, wobei der Schritt des Klebens vor den beiden Schritten des Formens durchgeführt wird; und der Schritt des Formens von mindestens einer Metallstruktur aus Folgendem besteht:
Definieren von mindestens einem Fenster durch die Halbleiterscheibe;
Formen von mindestens einer Metallstruktur innerhalb des mindestens einen Fensters durch die Halbleiterscheibe; und
Formen eines Mikroaktuators von der Halbleiterscheibe, so dass Teile des Mikroaktuatorbereichs, die relativ zum Träger beweglich sind, bei der Betätigung durchführbar die Metallstruktur einrasten.

10. Eine Methode gemäß Anspruch 6, wobei der Schritt des Klebens vor beiden Schritten des Formens durchgeführt wird;
der Schritt des Formens von mindestens einer Metallstruktur besteht aus dem Formen von mindestens einer Metallstruktur auf einer Oberfläche des Trägers, so dass die Metalistruktur relativ zur Substanz beweglich ist; und
der Schritt des Formens eines Mikroaktuators, der aus dem Formen eines Mikroaktuators von der Halbleiterscheibe besteht, so dass Teile des Mikroaktuators relativ zum Träger beweglich sind, damit die Metallstruktur bei der Betätigung durchführbar einrastet.

## Revendications

1. Dispositif microélectromécanique comportant un substrat microélectronique (40), un microactionneur (20) disposé sur le substrat, et au moins une structure (30) disposée sur le substrat et espacée du microactionneur, le microactionneur étant à même d'entrer en contact opérationnel avec la au moins une structure en réponse à l'actionnement de celui-ci, le dispositif microélectromécanique étant **caractérisé en ce que** :
le microactionneur est composé d'un matériau monocristallin, et
la au moins une structure est composée d'une structure métallique.

2. Dispositif microélectromécanique suivant la revendication 1, dans lequel la au moins une structure métallique comprend une pluralité de structures métalliques, et
au moins une (32) parmi la pluralité de structures métalliques peut se déplacer de sorte que l'actionnement thermique du microactionneur amène le microactionneur en contact opérationnel avec la structure métallique mobile, permettant de ce fait que la structure métallique mobile entre en contact avec au moins une (34) parmi la pluralité de structures métalliques de sorte que les structures métalliques peuvent être amenées sélectivement en contact en réponse à l'actionnement thermique du microactionneur.

3. Dispositif microélectromécanique suivant la revendication 1, **caractérisé en outre en ce que** le microactionneur et la au moins une structure métallique se trouvent sur un seul plan.

4. Dispositif microélectromécanique suivant la revendication 3, dans lequel le microactionneur est en outre **caractérisé par** :
au moins un stator (350) comportant une pluralité de dents (355) faisant saillie depuis celui-ci et disposé sur le substrat ;
au moins une navette (360) disposée à côté du stator et pouvant se déplacer par rapport à celui-ci, la navette comportant une pluralité de dents (365) faisant saillie de celle-ci, les dents étant interdigitées avec les dents faisant saillie du stator;
au moins un support (380, 390) disposé sur le substrat ;
un élément actionneur (370) accouplé en fonctionnement à la au moins une navette et au au moins un support, et
des moyens pour électriquement polariser le au moins un stator par rapport à la au moins une navette pour entraîner le déplacement de la navette de sorte que l'élément actionneur se déplace entre une première position dans laquelle l'élément actionneur est espacé de ladite au moins une structure métallique et une deuxième position dans laquelle l'élément actionneur vient en prise opérationnelle avec la au moins une structure métallique.

5. Procédé de fabrication d'un dispositif microélectromécanique comportant des composants formés d'un matériau monocristallin et des composants formés d'un matériau métallique suivant la revendication 1, comprenant les étapes suivantes :
la formation d'un microactionneur (20) à partir d'une tranche (50) en un matériau monocristallin ;
la formation d'au moins une structure métallique (30) sur un substrat (60) de sorte que la structure métallique peut se déplacer par rapport au substrat, et
la liaison de la tranche au substrat.

6. Procédé suivant la revendication 5, dans lequel l'étape de liaison est en outre exécutée avant l'une des étapes de formation ou les deux.

7. Procédé suivant la revendication 5, dans lequel la liaison du microactionneur à la première surface principale du substrat suit en outre les deux étapes de formation de sorte que des parties du microactionneur peuvent se déplacer par rapport au substrat pour venir en prise opérationnelle avec la structure métallique en réponse à l'actionnement de celui-ci.

8. Procédé suivant la revendication 7, dans lequel l'étape de formation d'au moins une structure métallique comprend les étapes suivantes :
le dépôt d'une couche de placage sacrificiel (62) sur un substrat;
le dépôt d'une résine photosensible (64) sur la couche de placage;
la formation des motifs de la résine photosensible pour ouvrir au moins une fenêtre (66) sur la couche de placage définissant la forme de la au moins une structure métallique, et
l'électrodéposition de métal (68) dans la au moins une fenêtre pour former la au moins une structure métallique.

9. Procédé suivant la revendication 6, dans lequel :
l'étape de liaison est exécutée avant les deux étapes de formation, et
l'étape de formation d'au moins une structure métallique comprend:
la définition d'au moins une fenêtre à travers la tranche ;
la formation d'au moins une structure métallique dans la au moins une fenêtre à travers la tranche, et
la formation d'un microactionneur à partir de la tranche de sorte que des parties du microactionneur peuvent se déplacer par rapport au substrat pour venir en prise opérationnelle avec la structure métallique en réponse à l'actionnement de celui-ci.

10. Procédé suivant la revendication 6, dans lequel :
l'étape de liaison est exécutée avant les deux étapes de formation ;
l'étape de formation d'au moins une structure métallique comprend la formation d'au moins une structure métallique sur une surface du substrat de sorte que la structure métallique peut se déplacer par rapport au substrat, et
l'étape de formation d'un microactionneur comprend la formation d'un microactionneur à partir de la tranche de sorte que des parties du microactionneur peuvent se déplacer par rapport au substrat afin de venir en prise opérationnelle avec la structure métallique en réponse à l'actionnement de celui-ci.
